# EUROPEAN PATENT APPLICATION

(11) **EP 2 570 262 A1**
(43) Date of publication of application: **20.03.2013**
(21) Application number: 12167539.1
(22) Date of filing: 10.05.2012
(51) Int. Cl.: B41F 15/36, B05C 17/08, B41N 1/24, H05K 3/12

(54) **Stencil for printing solder paste on printed circuit board**

(30) Priority: 16.09.2011 TW 100133342
(71) Applicant: Askey Technology (Jiangsu) Ltd., Economic-Technological Development Area Wujiang Jiangsu (CN); Askey Computer Corp., New Taipei City 235 (TW)
(72) Inventor: Chang, Shao Chun, 325 Taoyuan County (TW); Hsieh, Ching-Feng, 108 Taipei City (TW)
(74) Representative: Acco, Stefania

(57) **Abstract**

A stencil for printing solder paste on a printed circuit board improves an assembly process, cuts production costs, and saves storage space. The stencil (2) is coupled to a fixing frame (1) having a plurality of fixing portions (81) and a motor unit (13). The motor unit (13) generates a plurality of pulling forces (223). The stencil (2) includes a solder paste printing region (21) and a plurality of fixing regions (22). Vias (211) are disposed in the solder paste printing region (21). The directions of the pulling forces (223) are coplanar with the solder paste printing region (21). The edge of the solder paste printing region (21) extends outward to define the fixing regions (22). The fixing regions (22) are movably fixed to the fixing portions (81) and bear the pulling forces (223) to flatten the solder paste printing region (21) of the stencil (2).

## Description

### FIELD OF THE INVENTION

The present invention is related to stencils, particularly to a stencil for printing solder paste on a printed circuit board.

### BACKGROUND OF THE INVENTION

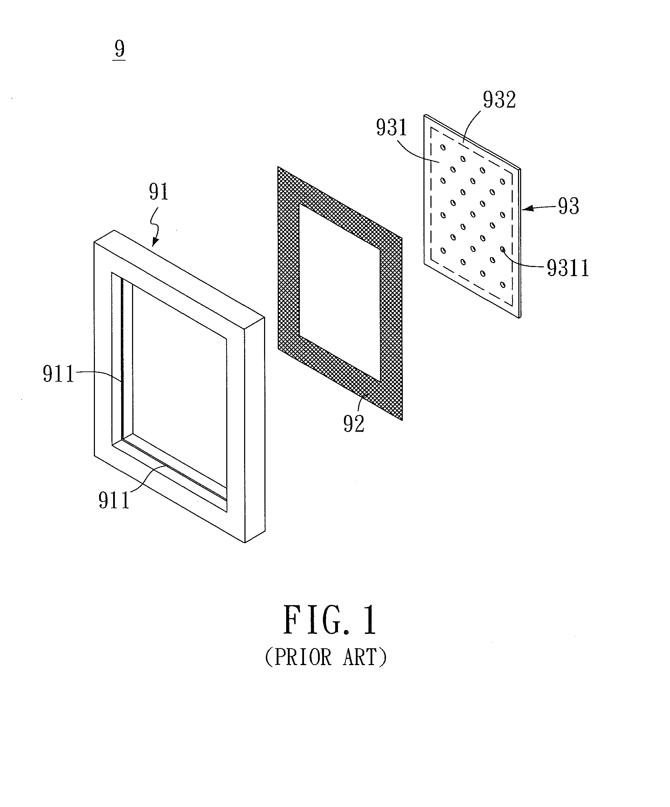

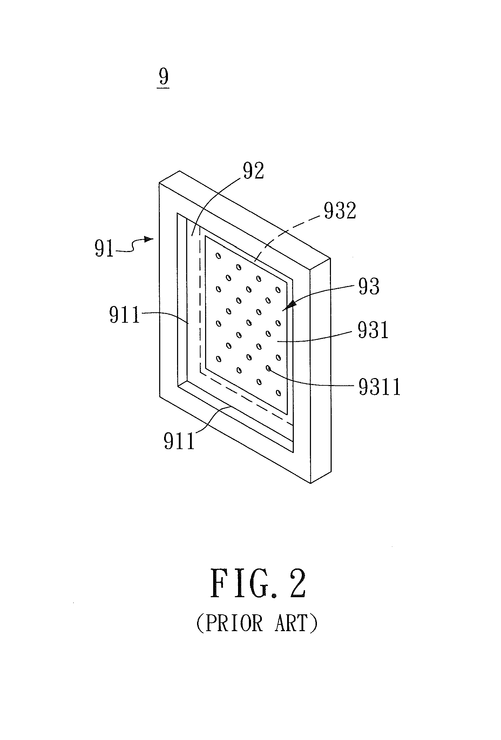

Figs. 1 and 2 are a disassembled diagram and an assembled diagram, respectively, of a conventional assembled solder paste printing structure for printing solder paste on a printed circuit board. As illustrated in these figures, printing solder paste on the printed circuit board presently is, generally, necessary to use the conventional assembled solder paste printing structure 9 comprising a fixing frame 91, a hollowed-out rectangular stretching net 92 and a steel plate 93. The steel plate 93 is rectangular and has a rectangular solder paste printing region 931 and a fixing region 932. The solder paste printing region 931 is surrounded, on its four sides, by the fixing region 932, and provided with a plurality of vias 9311 for providing solder paste. The fixing region 932 is used to be stuck to inner edges of four sides of the stretching net 92, in such a way that outer edges of four sides of the stretching net 92 may be applied with equal pulling forces to tension outwardly to flatten the steel plate 93, and then clampingly fixed in clamping slots 911 on at four sides of the fixing frame 91. When the conventional assembled solder paste printing structure 9 is used, a printed circuit board (not shown) is firstly fixed on a platform (not shown) of a machine (not shown) horizontally, followed by fixing the fixing frame 91 of the conventional assembled solder paste printing structure 9 on the machine, and lying the steel plate 93 of the conventional assembled solder paste printing structure 9 on the printed circuit board aligningly. Subsequently, solder paste is scraped across the solder paste printing region 931 of the steel plate 93, in such a way that the solder paste is provided within the vias 9311 of the steel plate 93 and applied to the printed circuit board. Finally, the conventional assembled solder paste printing structure 9 is removed. The printed circuit board is then coated with a plurality of spot-like solder paste, to be further processed.

For the conventional assembled solder paste printing structure, a whole structure, instead of a disassembled single steel plate, is required to correspond to each of a variety of printed circuit boards individually, resulting in the an increase in cost and occupation of storage space. In addition, the replacement or reproduction of the whole conventional assembled solder paste printing structure, instead of one single disassembled expired or damaged steel plate, is required needed when expiration or damage occurs, leading to wasting cost and consuming time. Moreover, the manufacturing process of fixing the steel plate of the conventional assembled solder paste printing structure in the fixing frame is complicated, because the steel plate should be stuck to the stretching net and then flattened.

Therefore, it is imperative to provide a stencil for printing solder paste on a printed circuit board so as to improve an assembly process, cut production costs, and save storage space.

### SUMMARY OF THE INVENTION

In view of above drawbacks of the prior art, the inventor of the present invention conducted extensive researches and experiments according to the inventor's years of experience in the related industry, and finally developed a stencil for printing solder paste on a printed circuit board, so as to improve an assembly process, cut production costs, and save storage space.

For achieving above objectives, a stencil for printing solder paste on a printed circuit board of the present invention is used for combining with a fixing frame having a plurality of fixing portions and a motor unit. The motor unit is used for providing a plurality of pulling forces. The stencil comprises a solder paste printing region, provided with a plurality of first vias, the pulling forces being coplanar with the solder paste printing region; and a plurality of fixing regions, defined by outward extensions of edges of the solder paste printing region, the fixing regions being movably fixed to the fixing portions and allowed to bear the pulling forces so as to flatten the solder paste printing region of the stencil.

Thereby, the objectives of easy to assemble, cutting cost and reducing storage space may be achieved by a fixing frame and an assembled fixing device for printing solder paste on a printed circuit board of the present invention

### BRIEF DESCRIPTION OF THE DRAWINGS

FIG. 1 is a disassembled diagram of a conventional assembled solder paste printing structure for manufacturing a printed circuit board;
Fig. 2 is an assembled diagram of a conventional assembled solder paste printing structure for manufacturing a printed circuit board;
Fig. 3 is a diagram of a fixing frame and pulling forces born by a stencil according to one embodiment of the present invention;
Fig. 4 is a diagram of a fixing region of the stencil according to the embodiment of the present invention;
Fig. 5 is a diagram of pulling forces born by a stencil according to another embodiment of the present invention; and
Fig. 6 is a diagram of pulling forces born by a stencil according to a further embodiment of the present invention.

### DETAILED DESCRIPTION OF THE PREFERRED EMBODIMENTS

A detailed description will be made to the present invention by means of following embodiments in cooperation with accompanied drawings for fully understanding the objectives, features and effects of the present invention.

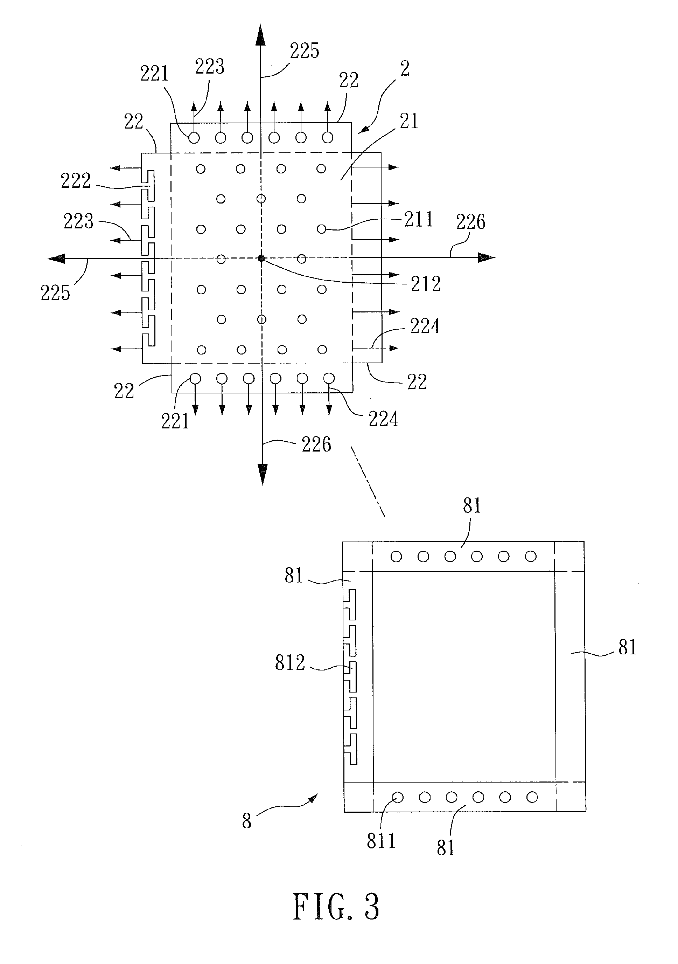

Fig. 3 is a diagram of a fixing frame and pulling forces born by a stencil according to one embodiment of the present invention. As illustrated in this figure, a stencil 2 for printing solder pasted on a printed circuit board (not shown) of the present invention is used for combining with a fixing frame 8 having a plurality of fixing portions 81 and at least one motor unit (not shown). The motor unit is used for providing a plurality of pulling forces 223. The fixing frame 8, shown in this figure, is a hollowed-out rectangular frame and provided with four fixing portions 81, in which top and bottom fixing portions 81 are provided with a plurality of circular snapping posts 811, while a left fixing portion 81 is provided with a plurality of T-shaped snapping posts 812. The stencil 2 comprises a solder paste printing region 21 and a plurality of fixing regions 22. The fixing regions 22 are defined by outward extensions of edges of the solder paste printing region 21. The solder paste printing region 21 is rectangular in appearance. The fixing regions 22 are defined by outward extensions of four edges of the solder paste printing region 21. The solder paste printing region 21 is provided with a plurality of first vias 211 passing through the stencil 2, and the pulling forces 223 are coplanar with the solder paste printing region 21. Due to the first vias 211, solder paste can be readily applied to the printed circuit board. As shown in this figure, the solder paste printing region 21 is provided with a plurality of vias 211 for holding a portion of the solder paste therein and further, applying the portion of the solder paste to the printed circuit board, after the solder paste is scraped across the solder paste printing region 21. The fixing regions 22 are movably fixed to the fixing portions 81 of the fixing frame 8 together and allowed to bear the pulling forces 223 equal in magnitude and coplanar with the solder paste printing region 21. The stencil 2, shown in this figure, is provided on the fixing frame 8, in which each of the fixing portions 22 is provided on each of the fixing portions 81, respectively, while the solder paste printing region 21 is then provided within the hollowed-out fixing frame 8. The right and bottom fixing regions 22 each may be defined to be movably clamped by the fixing portion 81 (for instance, the fixing portion 22 is clamped by top and bottom clamping plates (not shown)), while the left and top fixing regions 22 each may be defined to be movably snapped by the fixing portion 81 (for instance, second vias 221 are provided to circular snapping posts 811, or T-shaped snapping slots 222 are provided to T-shaped snapping posts 812). In addition, except for being movably clamped by the fixing portion 81, the bottom fixing portion 22 may be also movably snapped cooperatively, so as to avoid the relative slip between the fixing region 22 and the fixing portion 81. After all of the fixing regions 22 are combined with the fixing portions 81, the fixing portions 81 may be then moved outwardly, so as to apply the pulling forces 223 to each of the fixing regions 22, with the pulling forces 223 being combined to become a total pulling force 225 with respect to each fixing region 22. The stencil 2 may be assembled to the fixing frame 8 or dismounted therefrom easily and quickly by means of the fixing regions 22, as well as stored independently so as to save storage space, and replaced alone when it is replaced so as to reduce costs. Each fixing region 22, in addition, may be designed for movably snapping or movably clamping as required, and for bearing the pulling forces 223 or not for bearing a plurality of pulling forces. For two fixing regions 22 corresponding to each other, either of them may be designed for movably snapping or movably clamping, respectively, as well as either both of them may be designed for bearing the plurality of pulling forces 223, or one fixing region 22 is allowed for bearing the pulling forces 223, while the other fixing region 22 is not allowed for bearing a plurality of pulling forces. In fact, when one fixing region 22 is allowed for bearing the pulling forces 223, while the other fixing region 22 is not allowed for bearing a plurality of pulling forces, reaction forces 224 of the pulling forces 223 may be also generated actually in the other fixing region 22. That is to say, since the pulling forces 224 in the opposite direction with respect to the pulling forces 223 may be combined as a total pulling force 226 of the other fixing region 22, even if a plurality of pulling forces is not born, the reaction forces of the pulling forces 223 are still born by the other fixing region 22 necessarily. Furthermore, when the plurality of pulling forces 223 which is equal in magnitude and coplanar with the solder paste printing region 21 is born by the fixing regions 22, an uniform distribution of tension within the solder paste printing region 21 is ensured, and the concentration of stress at specific locations of the fixing regions 22 is also avoided because of an increased number of the pulling forces 223. Finally, the total pulling forces 225, 226 pass through a centroid 212 of the solder paste printing region 21, and the sum of the total pulling forces 225, 226 is zero, so as to flatten the solder paste printing region 21 of the stencil 2, in the case of non-deformation of the first vias 211. The deformation of the first vias 211 indicates that the stencil 2 is damaged and thus unusable. Therefore, it is also necessary to control the magnitude of the pulling forces 223 when the solder paste printing region 21 of the stencil 2 is flattened, so as to avoid the damage caused to the stencil 2 by the pulling forces 223. Moreover, the generation of torque within the solder paste printing region 21 and the displacement of the stencil 2 are avoided, when the total pulling forces 225, 226 pass through the centroid 212 of the solder paste printing region 21 and the sum of the total pulling forces 225, 226 is zero. To sum up, the stencil for printing solder paste on a printed circuit board of the present invention is precisely lain on the printed circuit board, so as for solder paste to be applied to the printed circuit board accurately.

Each of the above-mentioned fixing regions 22 is strip-like and is provided along the edge of the solder paste printing region 21. The fixing region 22 is strip-like, such that it is easy to manufacture and design as a movably clamping structure, and it is easy to design for use with the solder paste printing region 21 with a movably snapping structure.

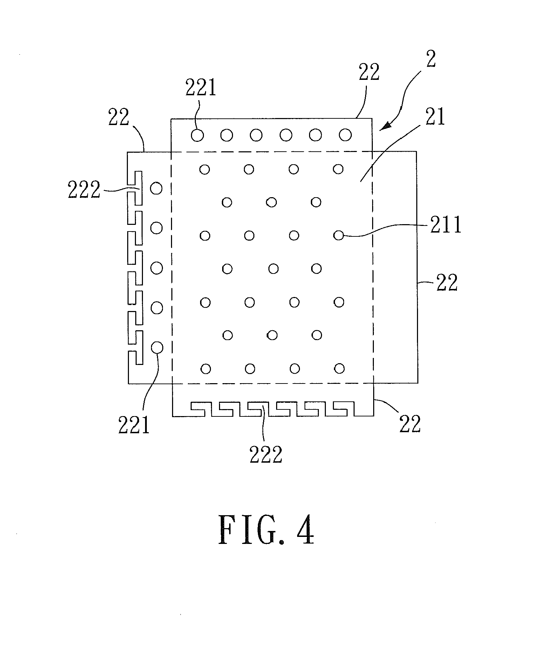

Fig. 4 is a diagram of the fixing region of the stencil according to the embodiment of the present invention. Referring to Fig. 3 together, as illustrated in these figures, the above-mentioned fixing region 22 may be provided with the plurality of second vias 221, the plurality of snapping slots 222, or the plurality of second vias 221 and the plurality of snapping slots 222, thereby movably fixed to the fixing portion 81 of the fixing frame 8 and allowed to bear the pulling forces 223. The second vias 221, the snapping slots 222, or the second vias 221 and the snapping slots 222 are easy for snapping to the exterior, such as snapping with a cylinder or snapping with a pillar having a shape corresponding to that of the snapping slot, for example, and they also hardly come off when the pulling forces 223 are born by the fixing region 22. In addition, the generation of slip between the fixing region 22 and the fixing portion 81 is truly avoided, when the movably clamped fixing region 22 is designed together with the second vias 221, the snapping slots 222, or the second vias 221 and the snapping slots 222.

The above-mentioned snapping slots 222 are L-shaped or T-shaped, or take any other shapes as appropriate, so as to be designed as a snapping structure.

The above-mentioned stencil 2 is made of metallic material, such as steel, for example, thus having the advantage of being capable of coming off solder paste more easily, in such a way that the solder paste can be accurately applied to the printed circuit board when the stencil 2 is separated from the printed circuit board.

The above-mentioned motion may be either movable snapping or movable clamping. In movably snapping, the second vias 221 or snapping slots 222, for example, are provide on the fixing region 22, followed by providing the second vias 221 to the circular snapping posts 811 on the fixing portion 81, or providing the T-shaped snapping slots 222 to the T-shaped snapping posts 812 on the fixing portion 81. In movably clamping, the fixing portion 81, for example, is provided with top and bottom clamping plates (not shown), so as to clamp the fixing region 22. Moreover, the puling forces are applied to the fixing regions 22 only if the snapping posts 811, 812 or top and bottom clamping plates are moved outwardly.

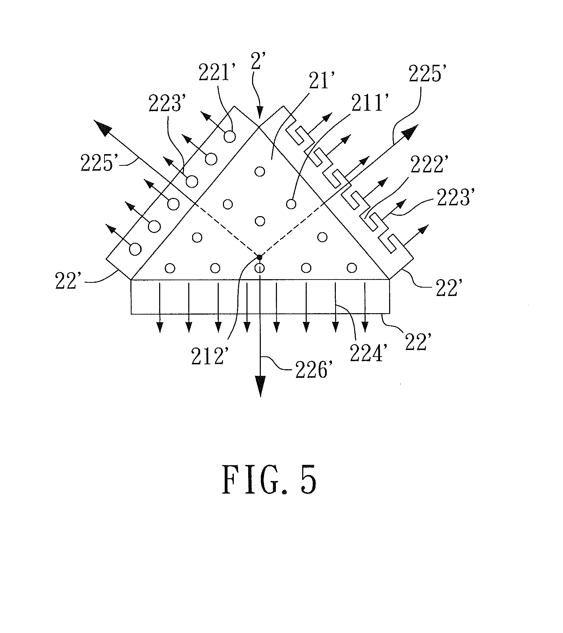

Fig. 5 is a diagram of pulling forces born by a stencil according to another embodiment of the present invention. As illustrated in Fig. 5, a solder paste printing region 21' of the present invention is triangular in appearance or takes any other shapes as appropriate, except for the above-mentioned rectangular solder paste printing region 21, as required, only if the condition of pulling forces 223' meets that stated above. As illustrated in Fig. 5, the fixing regions 22' at two legs are designed for being movably clamped (by means of second vias 221' and snapping slots 222'), and allowed to bear the plurality of pulling forces 223', which are equal in direction, equal in magnitude and coplanar with the solder paste printing region 21'. The fixing region 22' at the bottom is then designed for being movably clamped and generating reaction forces of the pulling forces 223' (pulling forces 224', in one direction opposite to that of the pulling forces 223' and combined as a total pulling force 226'). All of two total pulling forces 225' on the fixing portions 22' at two legs and the total pulling force 226' (the reaction force) on the bottom fixing region 22' pass through a centroid 212' of the solder paste printing region 21', and the sum of the total pulling forces 225', 226' is zero, in the case of non-deformation of the first vias 211'. Thereby, the solder paste printing region 21' in triangular shape is flattened. In addition, a plurality of pulling forces is born by the bottom fixing region 22' instead, and the solder paste printing region 21' in triangular shape is flattened, only if the condition of pulling forces meets that stated above.

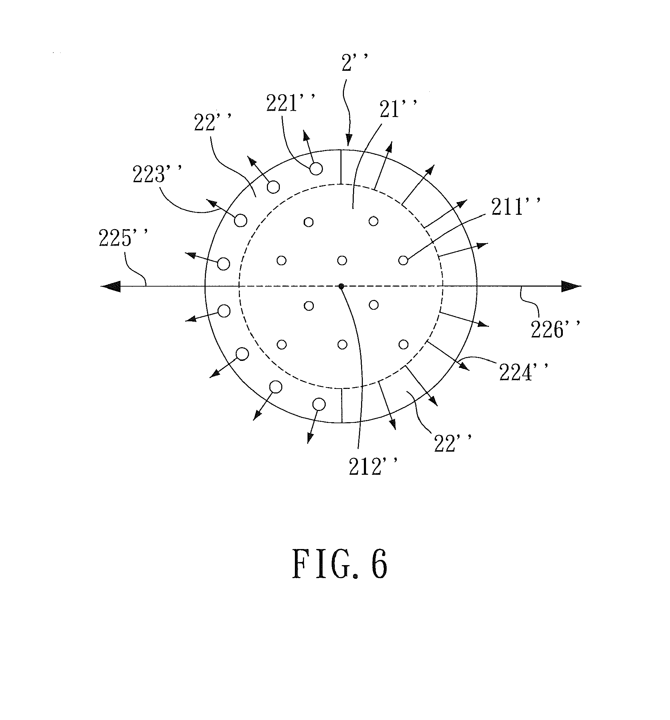

Fig. 6 is a diagram of pulling forces born by a stencil according to a further embodiment of the present invention. As illustrated in this figure, a solder paste printing region 21 " of the present invention is round in appearance or takes any other shapes as appropriate, except for the above-mentioned rectangular solder paste printing region 21, as required, only if the condition of pulling forces 223" meets that stated above. As illustrated in Fig. 6, a fixing region 22" on the left side is designed for being movably clamped (by means of second vias 221 "), and allowed to bear the plurality of pulling forces 223", which are directed radially, equal in magnitude and coplanar with the solder paste printing region 21 ". The fixing region 22" at right side is then designed for being movably clamped, and allowed to generate reaction forces of the pulling forces 223" (pulling forces 224", in one direction opposite to that of the pulling forces 223" and combined as a total pulling force 226"). Both of the total pulling forces 225" on the left fixing portions 22" and the total pulling force 226" (the reaction force) on the right fixing region 22" pass through a centroid 212" of the solder paste printing region 21 ", and the sum of the total pulling forces 225", 226" is zero, in the case of non-deformation of the first vias 211 ". Thereby, the solder paste printing region 21 " presented as a circle may be thus flattened. In addition, a plurality of pulling forces may be also born by the right fixing region 22" instead, and the solder paste printing region 21 " formed as a circle may be also thus flattened, only if the condition of pulling forces meets that stated above. Furthermore, the amount of 2 is designed for the fixing regions 22" in this embodiment, however, the amount of 3, 4 and etc., may be also possible as practically required.

The present invention is disclosed by embodiments in foregoing description. However, it should be understood by those skilled in the art that the embodiments are merely used for describing the present invention and not considered as restrictive. It should be noted, that all equivalent variations and substitutions may be included within the scope of the present invention. Therefore, the present invention to be protected should be defined by appended claims.

## Claims

1. A stencil for printing solder paste on a printed circuit board, used for combining with a fixing frame having a plurality of fixing portions and a motor unit, the motor unit being used for providing a plurality of pulling forces, the stencil comprising:
a solder paste printing region having a plurality of first vias and being coplanar with the pulling forces; and
a plurality of fixing regions defined by outward extensions of edges of the solder paste printing region and movably fixed to the fixing portions to bear the pulling forces so as to flatten the solder paste printing region of the stencil.

2. The stencil according to Claim 1, wherein each of the fixing regions is strip-like and is provided along the edge of the solder paste printing region.

3. The stencil according to Claim 1, wherein each of the fixing regions is provided with a plurality of second vias for being movably fixed to each of the fixing portions of the fixing frame to bear the pulling forces.

4. The stencil according to Claim 1, wherein each of the fixing regions is provided with a plurality of snapping slots for being movably fixed to each of the fixing portions of the fixing frame to bear the pulling forces.

5. The stencil according to Claim 4, wherein the snapping slots are L-shaped or T-shaped

6. The stencil according to Claim 1, wherein each of the fixing regions is provided with a plurality of second vias and a plurality of snapping slots for being movably fixed to each of the fixing portions of the fixing frame to bear the pulling forces.

7. The stencil according to Claim 6, wherein the snapping slots are L-shaped or T-shaped.

8. The stencil according to Claim 1, wherein the stencil is made of metallic material.

9. The stencil according to Claim 8, wherein the stencil is made of steel.

10. The stencil according to Claim 1, wherein the motion is one of movable snapping and movable clamping.
